(19) Europäisches Patentamt
European Patent Office
Office européen des brevets

(11) **EP 4 039 760 B1**

(12) **EUROPEAN PATENT SPECIFICATION**

(45) Date of publication and mention
of the grant of the patent:
**08.04.2026 Bulletin 2026/15**

(21) Application number: **20872317.1**

(22) Date of filing: **24.09.2020**

(51) International Patent Classification (IPC):
*C09G 1/02* *(2006.01)*  *C09K 3/14* *(2006.01)*
*B24B 37/00* *(2012.01)*  *H01L 21/304* *(2006.01)*
*H01L 23/544* *(2006.01)*  *H01L 21/02* *(2006.01)*

(52) Cooperative Patent Classification (CPC):
**C09G 1/02; H10P 90/129;** C09K 3/1463;
H10W 46/00; H10W 46/401

(86) International application number:
**PCT/JP2020/035921**

(87) International publication number:
**WO 2021/065644 (08.04.2021 Gazette 2021/14)**

(54) **POLISHING COMPOSITION**

POLIERZUSAMMENSETZUNG

COMPOSITION DE POLISSAGE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **30.09.2019 JP 2019180257
06.12.2019 JP 2019221258**

(43) Date of publication of application:
**10.08.2022 Bulletin 2022/32**

(73) Proprietor: **Fujimi Incorporated
Kiyosu-shi, Aichi 452-8502 (JP)**

(72) Inventors:
• **TANIGUCHI, Megumi**
**Kiyosu-shi, Aichi 452-8502 (JP)**
• **TSUCHIYA, Kohsuke**
**Kiyosu-shi, Aichi 452-8502 (JP)**

(74) Representative: **Grünecker Patent- und
Rechtsanwälte
PartG mbB
Leopoldstraße 4
80802 München (DE)**

(56) References cited:
WO-A1-2018/088371    WO-A1-2018/159530
WO-A1-2019/017407    CN-A- 105 623 526
CN-A- 107 828 340    JP-A- 2000 080 349
JP-A- 2005 526 145    JP-A- 2007 067 153
JP-A- 2015 155 523    JP-A- H09 306 880

## Description

## Technical Field

The present invention relates to polishing compositions. The present application claims priority based on Japanese Patent Applications No. 2019-180257 filed on 30 September 2019, and No. 2019-221258 filed on 6 December 2019.

## Background Art

Conventionally, precision polishing has been performed using polishing compositions on surfaces of material such as metals, metalloids, non-metals, and their oxides. For example, the surface of a silicon wafer, which is used as a component of a semiconductor product or the like, is generally finished to a high-quality mirror surface through lapping and polishing processes. The polishing process includes, for example, a pre-polishing step (preliminary polishing step) and a final polishing step (finish polishing step). The pre-polishing step includes, for example, a rough polishing step (primary polishing step) and an intermediate polishing step (secondary polishing step). Examples of a technical document relating to a composition for the preliminary polishing described above include Patent Literatures 1 and 2.

Further relevant documents represent: CN105623526 A and CN107828340 A.

Citation List

Patent Literature

> Patent Literature 1: Japanese Patent Application Publication No. H9-306880
> Patent Literature 2: Japanese Patent Application Publication No. 2018-107223

## Summary of Invention

Technical Problem

In Patent Literature 1, a polishing composition containing a water-soluble silicic acid component is considered for effectively polishing the surface of a silicon wafer in the above polishing process. Meanwhile, in Patent Literature 2, a combination of a water-soluble silicic acid component and a polyprotic acid is considered since the stability of polishing composition tends to decrease when a water-soluble silicic acid component is added to the polishing composition. However, these polishing compositions cannot satisfy polishing performance that has been required, especially in recent years.

For example, silicon wafers may be marked with barcodes, numbers, symbols, etc., (hard laser marks; hereinafter also referred to as "HLM") by irradiating the front or back surface of the silicon wafer with laser light for identification purposes or the like. The marking with HLM is generally conducted after the end of the lapping process of the silicon wafer and before the start of the polishing process thereof. Normally, the irradiation of a silicon wafer with laser light for marking HLM generates a stressed layer on a portion of the surface of the silicon wafer at the periphery of the HLM. Although the HLM part itself of the silicon wafer is not used in final products, if the stressed layer is not polished appropriately in the polishing process after the marking with the HLM, it may become a bump, causing unnecessary reduction in the yield. However, the above stressed layer is difficult to be polished because it is transformed to polysilicon or the like due to energy of the laser light. For this reason, in recent years, there has been a particular need for a polishing composition for silicon wafers to flatten a bump at the periphery of the HLM (hereinafter also simply referred to as a "bump").

Suppose that a silicon wafer marked with HLM is polished using a polishing composition exhibiting a high level of polishing removal rate (the amount of removal, per unit time, of an object to be polished), which is expected to improve polishing efficiency as described in Patent Literature 1. In this case, a portion of the silicon wafer, other than the above periphery of the HLM, which is polished more easily, may be more selectively polished than the portion of the silicon wafer at the periphery of the HLM which is hard to polish. As a result, improvement on bump cancellation ability becomes difficult to achieve. Therefore, there is a need for a polishing composition with excellent bump cancellation ability at the periphery of HLM periphery while satisfying the practical requirement level regarding polishing removal rate.

The present invention has been made in view of the foregoing points, and an object of the present invention is to provide a polishing composition that can achieve both high polishing removal rate and excellent bump cancellation ability at the periphery of HLM.

**Solution to Problem**

According to the present invention, a polishing composition is provided. The polishing composition comprising: an abrasive; a basic compound; a pH buffering agent; and water, wherein the polishing composition contains the abrasive in an amount of 10 weight% or less, the pH buffering agent contains a salt $S_L$ and a salt $S_H$, the salt $S_L$ having at least one of acid dissociation constant (pKa) values in a range of 9 to 11 and the salt $S_H$ having at least one of pKa values of 12 or more, the salt $S_H$ comprises at least one salt of a compound selected from the group consisting of silicic acid, germanic acid, arginine, nitrilotrismethylphosphonic acid, phosphoric acid and tetramethylguanidine, wherein the salt $S_H$ comprises an alkali metal salt, a ratio $(C_H/C_L)$ of a content $(C_H)$ of the salt $S_H$ to a content $(C_L)$ of a salt $S_L$ is 0.1 or more and 10 or less, and the pH of the polishing composition is 9.0 or higher.
Such a polishing composition can achieve both high polishing removal rate in terms of practical use and excellent bump cancellation ability at the periphery of HLM.

It is noted that cancellation of bumps at the periphery of the HLM as used herein refers to decreasing the height from a reference surface (reference plane) around the HLM on a silicon wafer to the highest point of the bump. The height from the reference surface around the HLM of the silicon wafer up to the highest point of the above bump can be measured, for example, by a method described in examples to be mentioned later.

The ratio $(C_H/C_L)$ of a content $(C_H)$ of the salt $S_H$ to a content $(C_L)$ of the salt $S_L$ is 0.1 or more and 10 or less. The polishing composition in which the salt $S_L$ and the salt $S_H$ are used at such a ratio as the pH buffering agent can more suitably cancel bumps at the periphery of the HLM, while maintaining sufficiently high polishing removal rate in terms of practical use.

In a preferred embodiment, the salt $S_H$ contains a salt of a compound selected from the group consisting of silicic acid, arginine, nitrilotrismethylphosphonic acid, phosphoric acid, and tetramethylguanidine. The bump cancellation effect at the periphery of the HLM can be exhibited more effectively by using the salt(s) of any or some of these compounds as the salt $S_H$ together with the salt $S_L$ in the pH buffering agent.

The polishing composition according to a preferred embodiment contains a carbonate as the salt $S_L$. The polishing composition in which the carbonate is used in combination with the salt $S_H$ as the pH buffering agent can suitably cancel bumps at the periphery of the HLM, while maintaining sufficiently high polishing removal rate in terms of practical use.

The polishing composition according to a preferred embodiment contains, as the pH buffering agent, a salt having an organic carbon. Such a polishing composition tends to suppress aggregation of abrasive particles in the composition, thereby improving the dispersion stability. The salt having the organic carbon is more preferably selected from an organic carbonate and an organic hydrogen carbonate.

In a preferred embodiment, the abrasive is silica particles. In polishing using silica particles as the abrasive, the bump cancellation effect can be exhibited more effectively.

The polishing composition according to a preferred embodiment contains a quaternary ammonium hydroxide as the basic compound. The bump cancellation at the periphery of the HLM is suitably achieved by the use of the quaternary ammonium hydroxide as the base compound. The polishing composition with the above constitution is preferable also in terms of improving the polishing removal rate.

The polishing composition disclosed herein can have excellent bump cancellation ability, i.e., excellent ability to cancel bumps at the periphery of the HLM. Therefore, the above polishing composition is suitable for applications of polishing a silicon wafer marked with HLM.

**Description of Embodiments**

Preferred embodiments of the present invention will be described below. Incidentally, matters that are other than those particularly mentioned in the present specification but are necessary for implementation of the present invention can be recognized by those skilled in the art as design matters based on the prior art in the relevant field. The present invention can be implemented based on contents disclosed in the present specification and common technical knowledge in the field.

<Abrasive>

The polishing composition disclosed herein contains an abrasive. The abrasive serves to mechanically polish the surface of an object to be polished. The material and properties of the abrasive are not particularly limited, but can be selected, as appropriate, depending on the purpose and application or the like of the polishing composition. The abrasives may be used alone or in combination of two or more kinds. Examples of the abrasive include inorganic particles, organic particles, and organic-inorganic composite particles. Specific examples of the inorganic particles include silicon compound particles such as silica particles, silicon nitride particles, and silicon carbide particles, diamond particles and the like.

Specific examples of the organic particles include polymethyl methacrylate (PMMA) particles, polyacrylonitrile particles and the like. Among these, inorganic particles are preferable.

As the abrasive in the art disclosed herein, silica particles are particularly preferable. The art disclosed herein can be preferably implemented in an embodiment in which the abrasive is substantially composed of silica particles, for example. The term "substantially" as used herein refers to 95 wt% or more of particles constituting the abrasive (preferably 98 wt% or more, and more preferably 99 wt% or more, and it may be 100 wt%), which are composed of silica particles.

The kind of silica particles is not particularly limited, but can be selected as appropriate. The silica particles may be used alone or in combination of two or more kinds. Examples of the silica particles include colloidal silica, fumed silica, precipitated silica and the like. Colloidal silica is particularly preferable because it can exhibit favorable polishing performance (such as performance in reducing the surface roughness) while suppressing the occurrence of scratches on a polished surface of the object. The kind of colloidal silica is not particularly limited, but can be selected as appropriate. The colloidal silica may be used alone or in combination of two or more kinds. Colloidal silica prepared by an ion exchange method using water glass (Na silicate) as a raw material and alkoxide method colloidal silica can be preferably adopted as an example of the colloidal silica. Herein, the alkoxide method colloidal silica refers to colloidal silica produced by a hydrolytic condensation reaction of an alkoxysilane.

The true specific gravity of silica constituting silica particles is preferably 1.5 or more, more preferably 1.6 or more, and even more preferably 1.7 or more. The polishing removal rate tends to become higher with increasing true specific gravity of silica. From this perspective, silica particles having a true specific gravity of 2.0 or more (for example, 2.1 or more) are particularly preferable. The upper limit of the true specific gravity of silica is not particularly limited, but is, for example, 2.3 or less, or 2.2 or less. A measured value obtained by a liquid displacement method using ethanol as a displacement liquid can be adopted as the true specific gravity of silica.

The average primary particle diameter of the abrasive is not particularly limited, but can be selected as appropriate from a range of about 10 nm to 200 nm, for example. From the viewpoint of improving the bump cancellation ability, the average primary particle diameter thereof is preferably 20 nm or more, and more preferably 30 nm or more. In some embodiments, the average primary particle diameter may be, for example, more than 40 nm, more than 45 nm, or more than 50 nm. From the viewpoint of preventing occurrence of scratches, the average primary particle diameter is 150 nm or less, which is normally advantageous, and is preferably 120 nm or less, and more preferably 100 nm or less. In some embodiments, the average primary particle diameter may be 75 nm or less, or 60 nm or less.

In the present specification, the average primary particle diameter of the abrasive refers to a particle diameter that is calculated from the specific surface area (BET value) measured by a BET method on the basis of the following formula: average primary particle diameter (nm) = $6000/(\text{true density (g/cm}^3) \times \text{BET value (m}^2/\text{g}))$. For example, in the case of silica particles, the average primary particle diameter can be calculated from the following formula: average primary particle diameter (nm) = $2727/\text{BET value (m}^2/\text{g})$. The specific surface area can be measured, for example, by using a surface area measuring device "FlowSorb II 2300" (trade name) manufactured Micromeritics Instrument Corporation.

The average secondary particle diameter of the abrasive is not particularly limited, but can be selected as appropriate from a range of about 15 nm to 300 nm, for example. From the viewpoint of improving the bump cancellation ability, the average secondary particle diameter thereof is preferably 30 nm or more, and more preferably 35 nm or more. In some embodiments, the average secondary particle diameter may be, for example, 40 nm or more, or 45 nm or more, and may be preferably 50 nm or more, further 60 nm or more, or 65 nm or more (for example, 70 nm or more). From the viewpoint of preventing occurrence of scratches, the average secondary particle diameter is 250 nm or less, which is normally advantageous, and is preferably 200 nm or less, and more preferably 150 nm or less. In some embodiments, the average secondary particle diameter may be 120 nm or less, or 100 nm or less.

In the present specification, the average secondary particle diameter of the abrasive refers to a particle diameter measured by a dynamic light scattering method. For example, this measurement can be performed using "Nanotrak (registered trademark) UPA-UT151" manufactured by Nikkiso Co., Ltd., or "FPAR-1000" manufactured by Otsuka Electronics Co., Ltd.

The shape (outer shape) of the abrasive may be globular or non-globular. Specific examples of the non-globular shape of the abrasive include a peanut shape (i.e., a peanut shell shape), a cocoon shape, a conpeito shape, a rugby-ball shape, etc. From the viewpoint of achieving both bump cancellation ability and reduction of scratches, the shape of the abrasive is preferably globular.

The average aspect ratio of the abrasive is not particularly limited. The average aspect ratio of the abrasive is 1.0 or higher in principle, and can be 1.05 or higher, or 1.1 or higher. The bump cancellation ability generally tends to improve with increasing average aspect ratio. From the viewpoint of reduction of scratches and improvement in the stability of polishing, for example, the average aspect ratio of the abrasive is preferably 3.0 or lower, and more preferably 2.0 or lower. In some embodiments, the average aspect ratio of the abrasive may be, for example, 1.5 or lower, 1.4 or lower, or 1.3 or lower.

The shape (outer shape) and average aspect ratio of the abrasive can be grasped by, for example, observation with an electron microscope. A specific procedure for grasping the average aspect ratio includes, for example, drawing a minimum rectangle circumscribing each particle image for a predetermined number (for example, 200 particles) of abrasive particles in which the shape of an independent particle can be recognized by using a scanning electron microscope (SEM). Then, for the rectangle drawn for each particle image, a value obtained by dividing the length of the long side (long diameter value) by the length of the short side (short diameter value) is calculated as the ratio of the long diameter to the short diameter (aspect ratio). By arithmetically averaging the aspect ratios of the above predetermined number of particles, the average aspect ratio can be determined.

The degree of association of the abrasive is not particularly limited. The degree of association of the abrasive is 1.0 or more in principle, and can be 1.05 or more, or 1.1 or more. From the viewpoint of reduction of scratches and improvement in the stability of polishing, for example, the degree of association of the abrasive is preferably 3.0 or less, and more preferably 2.0 or less. In some embodiments, the degree of association of the abrasive may be, for example, 1.8 or less, or 1.75 or less. The degree of association of the abrasive in the present specification refers to an average value of the ratio of the average secondary particle diameter/average primary particle diameter of the abrasive.

The content of the abrasive in the polishing composition is not particularly limited, but can be set as appropriate depending on its purpose. The content of the abrasive relative to the entire weight of the polishing composition may be, for example, 0.01 wt% or more, 0.05 wt% or more, or 0.1 wt% or more. The bump cancellation ability of the polishing composition generally tends to improve with increasing content of the abrasive. In some embodiments, the content of the abrasive may be 0.2 wt% or more, 0.5 wt% or more, or 0.6 wt% or more. In some embodiments, from the viewpoint of preventing scratches and saving the amount of used abrasive, the content of the abrasive may be, for example, 10 wt% or less, 5 wt% or less, 3 wt% or less, 2 wt% or less, 1.5 wt% or less, 1.2 wt% or less, or 1.0 wt% or less. These contents can be preferably applied to the content of an abrasive in a polishing slurry (working slurry) supplied to an object to be polished, for example.

In the case of a polishing composition that is diluted and used for polishing (i.e., a concentrate), the content of the abrasive is normally appropriately 50 wt% or less, and more preferably 40 wt% or less from the viewpoint of storage stability, filterability and the like. From the viewpoint of making use of the advantage of producing the polishing composition in the form of a concentrate, the content of the abrasive is preferably 1 wt% or more, and more preferably 5 wt% or more.

<Basic Compound>

The polishing composition disclosed herein contains a basic compound. The basic compound herein refers to a compound that has the function of increasing a pH of the polishing composition by being added to the composition. The basic compound acts to chemically polish the surface to be polished and can contribute to improving the polishing removal rate.

The basic compounds may be used alone or in combination of two or more kinds. As the basic compound, an organic or inorganic basic compound containing nitrogen, an alkali metal hydroxide, an alkaline earth metal hydroxide and the like can be used. Examples of the basic compound include alkali metal hydroxides, quaternary ammonium compounds such as quaternary ammonium hydroxides, ammonia, amines and the like. Specific examples of the alkali metal hydroxide include potassium hydroxide, sodium hydroxide and the like. Specific examples of the quaternary ammonium compound include tetramethylammonium hydroxide, tetraethylammonium hydroxide, tetrabutylammonium hydroxide and the like. Specific examples of the amine include methylamine, dimethylamine, trimethylamine, ethylamine, diethylamine, triethylamine, ethylenediamine, monoethanolamine, N-(β-aminoethyl)ethanolamine, hexamethylenediamine, diethylenetriamine, triethylenetetramine, piperazine anhydride, piperazine hexahydrate, 1-(2-aminoethyl)piperazine, N-methylpiperazine, guanidine, azoles such as imidazole and triazole and the like.

From the viewpoint of improvement in the bump cancellation ability and the like, examples of the preferred basic compound include quaternary ammonium hydroxides. The quaternary ammonium hydroxides may be used alone or in combination of two or more kinds. Tetramethylammonium hydroxide is particularly preferably used.

From the viewpoint of polishing removal rate and bump cancellation ability, the content of the basic compound relative to the entire weight of the polishing composition is preferably 0.01 wt% or more, more preferably 0.05 wt% or more, and even more preferably 0.1 wt% or more. The stability of the polishing composition can also be improved with increasing content of the basic compound. The upper limit of the content of the basic compound is appropriately 5 wt% or less, preferably 2 wt% or less, more preferably 1 wt% or less, and even more preferably 0.5 wt% or less from the viewpoint of surface quality and the like. When using a combination of two or more kinds of basic compounds, the above content refers to the total content of the two or more kinds of basic compounds. These contents can be preferably applied to the content in a polishing slurry (working slurry) supplied to an object to be polished, for example.

In the case of a polishing composition that is diluted and used for polishing (i.e., a concentrate), the content of the basic compound is normally appropriately 10 wt% or less, and more preferably 5 wt% or less from the viewpoint of storage stability, filterability and the like. From the viewpoint of making use of the advantage of producing the polishing composition in the form of a concentrate, the content of the basic compound is preferably 0.1 wt% or more, more preferably 0.5 wt% or more, and even more preferably 0.9 wt% or more.

< pH Buffering Agent>

The polishing composition disclosed herein contains, as a pH buffering agent, a salt $S_L$ having at least one of the acid dissociation constant (pKa) values in the range of 9 to 11 (hereinafter simply referred to as a "salt $S_L$") and a salt $S_H$ having at least one of the pKa values of 12 or more (hereinafter simply referred to as a "salt $S_H$"). As the value of pKa, the value of the acid dissociation constant at 25°C described in known publications can be adopted. By using a combination of two or more kinds of salts whose pKa values are different in the above respective ranges as the pH buffering agent, it is possible to more suitably cancel bumps at the periphery of the HLM, while maintaining sufficiently high polishing removal rate in terms of practical use. It is not necessary to elucidate the mechanism by which the salt $S_L$ and the salt $S_H$ contribute to maintaining high polishing removal rate and improving the bump cancellation ability in implementing the art disclosed herein. However, it is considered that when the above polishing composition is used, for example, for polishing as a working slurry having a pH of about 8.0 to 11.8, the buffering effect can be exhibited more effectively by combining such two or more kinds of salts whose pKa values are different in the above respective ranges. Because of this buffering effect, in the polishing composition with such a configuration, its pH that has been increased by the addition of the salt $S_H$ is maintained during polishing, which can promote the action of chemically polishing the surface to be polished and contribute to the maintenance of high polishing removal rate. Meanwhile, it is also considered that, by using the salt $S_L$ in combination with the salt $S_H$, the concentration of salts in the polishing composition increases, and the electrostatic repulsion between the abrasive and the surface of the object to be polished is suppressed, which can contribute to suitable cancellation of bumps at the periphery of the HLM. However, this situation is not interpreted to be limited to this mechanism.

(Salt $S_L$)

The above salt $S_L$ is not particularly limited as long as it has at least one of pKa values in the range of 9 to 11. The salts $S_L$ may be used alone or in combination of two or more kinds. An inorganic salt or organic salt that has at least one of pKa values in the range of, for example, 9 to 11 can be used as the salt $S_L$. An example of the inorganic acid is carbonic acid. Examples of the organic acid include histidine, tryptophan, tyrosine, and 4-aminopyridine. Examples of the above salt $S_L$ can include alkali metal salts such as sodium and potassium salts of the above inorganic or organic acids, ammonium salts thereof and the like. Preferred examples of the salt $S_L$ include carbonates. In particular, examples of the preferred salt $S_L$ include sodium carbonate, potassium carbonate, sodium hydrogen carbonate, potassium hydrogen carbonate, tetraalkylammonium carbonates, and tetraalkylammonium hydrogen carbonates (tetramethylammonium hydrogen carbonate, tetraethylammonium hydrogen carbonate, tetrabutylammonium hydrogen carbonate, etc.). Among these, potassium carbonate ($K_2CO_3$), and tetraalkylammonium hydrogen carbonates (for example, tetramethylammonium hydrogen carbonate) are preferable.

The content of the salt $S_L$ is not particularly limited. However, from the viewpoint of the bump cancellation ability and the like, the content of the salt $S_L$ relative to the entire weight of the polishing composition may be, for example, 0.01 wt% or more, 0.02 wt% or more, or 0.05 wt% or more. In some embodiments, from the viewpoint of dispersion stability of the polishing composition and the like, the above content may be, for example, 10 wt% or less, 5 wt% or less, 3 wt% or less, 1 wt% or less, or 0.5 wt% or less (for example, 0.2 wt% or less). These contents can be preferably applied to the content in a polishing slurry (working slurry) supplied to the object to be polished, for example.

The content of the salt $S_L$ in the polishing composition disclosed herein can also be specified by its relative relationship with the abrasive contained in the polishing composition. Specifically, the content of the salt $S_L$ in the polishing composition relative to 100 parts by weight of the abrasive is appropriately about 0.01 parts by weight or more, and from the viewpoint of the bump cancellation ability, it is preferably about 0.1 parts by weight or more, and more preferably about 1 part by weight or more (for example, about 5 parts by weight or more). From the viewpoint of dispersion stability and the like, the content of the salt $S_L$ relative to 100 parts by weight of the abrasive is appropriately about 200 parts by weight or less, preferably about 100 parts by weight or less, and more preferably about 50 parts by weight or less (for example, about 40 parts by weight or less).

The content of the salt $S_L$ can be set so that its buffering effect is suitably exhibited in relation to the basic compound. The polishing composition configured to exhibit such a buffering effect has less pH fluctuation during polishing and can have an excellent capability of maintaining polishing removal rate, so that it can suitably achieve both the improvement in the bump cancellation ability and the maintenance of high polishing removal rate. The content of the salt $S_L$ in the polishing composition disclosed herein can also be specified by its relative relationship with the basic compound contained in the polishing composition. Specifically, the content of the salt $S_L$ in the polishing composition relative to 100 parts by weight of the basic compound is appropriately about 0.1 parts by weight or more, and from the viewpoint of the bump cancellation ability, it is preferably about 1 part by weight or more, and more preferably about 5 parts by weight or more (for example, about 10 parts by weight or more). From the viewpoint of dispersion stability and the like, the content of the salt $S_L$ relative to 100 parts by weight of the basic compound is appropriately about 500 parts by weight or less, preferably about 200 parts by weight or less, and more preferably about 100 parts by weight or less (for example, about 80 parts by weight or less).

(Salt $S_H$)

The above salt $S_H$ is not particularly limited as long as it has at least one of pKa values of 12 or more. The salts $S_H$ may be used alone or in combination of two or more kinds. An inorganic salt or organic salt that has at least one of pKa values of 12 or more, for example, can be used as the salt $S_H$. Examples of the inorganic acid include silicic acid, germanic acid, and phosphoric acid. Examples of the organic acid include arginine, nitrilotrismethylphosphonic acid (NTPO), and tetramethylguanidine. Examples of the above salt $S_H$ can include alkali metal salts such as sodium or potassium salts of the above inorganic or organic acids, ammonium salts thereof and the like. Preferred examples of the salt $S_L$ include silicates. In particular, examples of the preferred salt $S_H$ include ammonium silicate, sodium silicate, and potassium silicate. Among these, potassium silicate is preferable.

The content of the salt $S_H$ is not particularly limited. However, from the viewpoint of polishing removal rate, the content of the salt $S_H$ relative to the entire weight of the polishing composition may be, for example, 0.01 wt% or more, 0.02 wt% or more, or 0.05 wt% or more. In some embodiments, from the viewpoint of dispersion stability of the polishing composition or the like, the above content may be, for example, 20 wt% or less, 10 wt% or less, 5 wt% or less, 3 wt% or less, or 1 wt% or less (for example, 0.5 wt% or less). These contents can be preferably applied to the content in a polishing slurry (working slurry) supplied to the object to be polished, for example.

The content of the salt $S_H$ in the polishing composition disclosed herein can also be specified by its relative relationship with the content of the salt $S_L$ contained in the polishing composition. Specifically, the ratio ($C_H/C_L$) of the content ($C_H$) of the salt $S_H$ to the content ($C_L$) of the salt $S_L$ is appropriately 0.01 or more, and from the viewpoint of achieving both the bump cancellation ability and the polishing removal rate, it is preferably 0.1 or more, and more preferably 0.2 or more (for example, 0.5 or more). From the viewpoint of dispersion stability and the like, the above ratio ($C_H/C_L$) is appropriately 100 or less, preferably 50 or less, and more preferably 10 or less, and may be 5 or less (for example, 2 or less).

(Salt having an organic carbon)

The polishing composition disclosed herein preferably further contains a salt having an organic carbon as a pH buffering agent, in the form of either the above salt $S_L$ or salt $S_H$, or in addition to at least one kind of the above salts $S_L$ and at least one kind of the above salts $S_H$. This improves the dispersion stability of the polishing composition. The reason for this improvement is interpreted not to be particularly limited, but the salt having the organic carbon tends to have a bulkier structure than an inorganic salt, which is thought to contribute to the suppression of aggregation of the abrasive particles and to the improvement in the dispersion stability of the polishing composition.

As the salt having the organic carbon, it is preferable to use one corresponding to either the salt $S_L$ (the salt having at least one of pKa values in the range of 9 to 11) or the salt $S_H$ (the salt having at least one of pKa values of 12 or more). Using such a salt having the organic carbon contributes to the improvement in the dispersion stability while exhibiting the function as the salt $S_L$ or $S_H$. Among them, the salt having the organic carbon is preferably the salt $S_L$ from the viewpoint of achieving both the buffering effect and the improvement in the dispersion stability.

When the salt having the organic carbon is one of the salts $S_L$, the content of the salt having the organic carbon preferably falls within the range of the content of the above salts $S_L$ also including the remaining salts $S_L$ which is different from the salt having the organic carbon. The content of the above salts $S_L$ herein refers to any of the content thereof with respect to the entire weight of the polishing composition, the content thereof based on the relative relationship with the abrasive, and the content thereof based on the relative relationship with the basic compound. Similarly, when the salt having the organic carbon is one of the salts $S_H$, the content of the salt having the organic carbon preferably falls within the range of the content of the above salts $S_H$ also including the remaining salts $S_H$ which is different from the salt having the organic carbon. The content of the above salts $S_H$ herein refers to any of the content thereof with respect to the entire weight of the polishing composition, the content thereof based on the relative relationship with the abrasive, and the content thereof based on the relative relationship with the basic compound.

Various kinds of salts having an organic carbon can be used as the salt having the organic carbon. The salts having the organic carbon may be used alone or in combination of two or more kinds. As the salt having the organic carbon, one that corresponds to the salt having the organic carbon among the salts of inorganic acid and organic acid can be used. The inorganic or organic acid constituting such a salt can be one or more kinds of inorganic or organic acids exemplified above in the salts $S_L$ and $S_H$. Among them, a salt of an inorganic acid is preferable, and a carbonate (a carbonate and a hydrogen carbonate) is more preferable. These salts are configured by having an inorganic compound (carbonic acid) as the anion, so that the organic carbon is present on the cation side. Such carbonates (carbonates and hydrogen carbonates) are also referred to as organic carbonates (organic carbonates and organic hydrogen carbonates).

The organic carbon in the salt having the organic carbon refers to the carbon (carbon atom(s)) that constitutes an organic group and an organic compound, which is not particularly limited as far as this is concerned. Typically, the above organic carbon can be a carbon (carbon atom(s)) constituting an organic group. Therefore, the salt having the organic carbon can be a salt having an organic group. The organic group above is not particularly limited, but is preferably a hydrocarbon group. Examples of such an organic group include alkyl groups such as a methyl group, an ethyl group, a propyl group, and a butyl group. Preferred examples of such a salt having the organic carbon include alkylammonium salts and alkylphosphonium salts, and among them, alkylammonium salts are particularly preferable. Specific examples thereof include tetraalkylammonium carbonates, such as tetramethylammonium carbonate, tetraethylammonium carbonate, and tetrabutylammonium carbonate; tetraalkylphosphonium carbonates such as tetrabutylphosphonium carbonate; tetraalkylammonium hydrogen carbonates such as tetramethylammonium hydrogen carbonate, tetraethylammonium hydrogen carbonate, and tetrabutylammonium hydrogen carbonate; tetraalkylphosphonium hydrogen carbonates such as tetrabutylphosphonium hydrogen carbonate; and the like. Among these, tetraalkylammonium hydrogen carbonates are preferable, and tetramethylammonium hydrogen carbonate is more preferable. The salts having these organic carbons may be salts other than hydroxides (salts that do not contain hydroxyl groups). The salts having these organic carbons may be used alone or in combination of two or more kinds.

In an embodiment where the salt having the organic carbon is the salt $S_L$ (the salt having at least one of pKa values in the range of 9 to 11), the above salts $S_L$ preferably contain at least one kind of salt having the organic carbon and at least one kind of salt not corresponding to the salt having the organic carbon (in other words, an inorganic salt). By using a combination of the inorganic salt and the salt having the organic carbon as the salts $S_L$, the polishing composition with improved polishing removal rate, bump cancellation ability, and dispersion stability can be easily obtained. As the inorganic salt, one or more kinds of salts of inorganic acids (for example, a salt having an inorganic carbon) exemplified as the salt $S_L$ can be used, and among them, carbonates such as potassium carbonate are preferable.

In an embodiment where the salt having the organic carbon is the salt $S_L$ (the salt having at least one of pKa values in the range of 9 to 11), the proportion of the salt having the organic carbon in the total weight of the above salts $S_L$ is, for example, appropriately 1 wt% or more, and from the viewpoint of improving the dispersion stability, it is preferably 10 wt% or more, and more preferably 30 wt% or more, and may be 50 wt% or more, or 70 wt% or more. The upper limit of the proportion of the salt having the organic carbon in the total weight of the above salts $S_L$ is not particularly limited and may be 100 wt%, or 99 wt% or less. From the viewpoint of the bump cancellation ability and the like, it is preferably 90 wt% or less, and may be 80 wt% or less, or 50 wt% or less. For example, when the salt of the inorganic acid (suitably carbonate) and the salt having the organic carbon (suitably tetraalkylammonium hydrogen carbonate) are used in combination as the salt $S_L$, it is preferable to use the salt having the organic carbon in the above proportion.

In an embodiment where the salt having the organic carbon is the salt $S_H$ (the salt having at least one of pKa values of 12 or more), the above salts $S_H$ can contain at least one kind of salt having the organic carbon and at least one kind of salt not corresponding to the salt having the organic carbon (in other words, an inorganic salt). By using a combination of an inorganic salt and the salt having the organic carbon as the salts $S_H$, the polishing composition with improved polishing removal rate, bump cancellation ability, and dispersion stability can be easily obtained. As the inorganic salt, one or more kinds of salts of inorganic acids exemplified as the salt $S_H$ can be used, and among them, silicates, such as potassium silicate, are preferable.

The polishing composition disclosed herein may contain, as the pH buffering agent, two kinds of salts (i.e., one kind of salt $S_L$ and one kind of salt $S_H$), or may contain three or more kinds of salts. For example, it can contain three or more kinds of salts as the pH buffering agent that include one kind of salt $S_L$ and one kind of salt $S_H$ and further include a salt corresponding to either the salt $S_L$ or the salt $S_H$, or a salt corresponding to neither the salt $S_L$ nor the salt $S_H$. Among these salts, one kind of salt described above is preferably the salt having the organic carbon from the viewpoint of dispersion stability. The above salt having the organic carbon preferably corresponds to either the salt $S_L$ or the salt $S_H$.

The polishing composition according to some preferred embodiments contains at least one kind of inorganic salt as the salt $S_L$ (typically, a salt of an inorganic acid, for example, a salt having an inorganic carbon, specifically, a carbonate such as potassium carbonate), at least one kind of inorganic salt as the salt $S_H$ (for example, a salt of an inorganic acid), and at least one kind of salt having the organic carbon which corresponds to either the salt $S_L$ or the salt $S_H$. By using the polishing composition having such a composition, both high polishing removal rate and the bump cancellation ability can be achieved while maintaining the improved dispersion stability.

In an embodiment where the salt having the organic carbon is the salt $S_H$ (the salt having at least one of pKa values of 12 or more), the proportion of the salt having the organic carbon in the total weight of the above salts $S_H$ is, for example, appropriately 1 wt% or more, and from the viewpoint of improving the dispersion stability, it is preferably 10 wt% or more, and more preferably 30 wt% or more, and may be 50 wt% or more, or 70 wt% or more. The upper limit of the proportion of the salt having the organic carbon in the total weight of the above salts $S_H$ is not particularly limited and may be 100 wt%, or 99 wt% or less. From the viewpoint of polishing removal rate and the like, it is preferably 90 wt% or less, and may be 80 wt% or less, or 50 wt% or less.

The proportion of the salt having the organic carbon in the total weight of the pH buffering agent is not particularly limited, but is, for example, appropriately 1 wt% or more, and from the viewpoint of improving dispersion stability, it is preferably 10 wt% or more, and more preferably 30 wt% or more, and may be 50 wt% or more. The portion of the salt having the organic carbon in the total weight of the pH buffering agent is appropriately 99 wt% or less, and from the viewpoint of bump cancellation ability, polishing removal rate and the like, it is preferably 90 wt% or less, and more preferably 70 wt% or less, and it may be 60 wt% or less, 50 wt% or less, 10 wt% or less, or 3 wt% or less.

The content of the salt having the organic carbon is not particularly limited. However, from the viewpoint of improving the pH buffering effect and the dispersion stability, or the like, the above content relative to the entire weight of the polishing composition may be, for example, 0.01 wt% or more, 0.02 wt% or more, or 0.05 wt% or more. In some embodiments, from the viewpoint of dispersion stability of the polishing composition and the like, the above content may be, for example, 10 wt% or less, 5 wt% or less, 3 wt% or less, 1 wt% or less, or 0.5 wt% or less (for example, 0.2 wt% or less). These contents can be preferably applied to the content in a polishing slurry (working slurry) supplied to the object to be polished, for example. The polishing composition according to some embodiments may substantially contain no salt having an organic carbon.

In the case of a polishing composition that is diluted and used for polishing (i.e., a concentrate), the total content of pH buffering agents (including the salt $S_L$ and the salt $S_H$, and further the salt having the organic carbon) relative to the entire weight of the concentrate is normally appropriately 20 wt% or less, preferably 10 wt% or less, and more preferably 8 wt% or less (for example, 5 wt% or less) from the viewpoint of storage stability, filterability and the like. From the viewpoint of making use of the advantage of producing the polishing composition in the form of a concentrate, the total content of the pH buffering agents is preferably 0.01 wt% or more, more preferably 0.1 wt% or more, and even more preferably 0.3 wt% or more.

<Water>

The polishing composition disclosed herein contains water. As the water, ionexchange water (deionized water), pure water, ultrapure water, distilled water, or the like can be preferably used. The water to be used preferably has a total content of transition metal ions of, for example, 100 ppb or less in order to avoid hindering the action of other components contained in the polishing composition as much as possible. For example, the purity of water can be enhanced by removal of impurity ions derived from an ion exchange resin, removal of impurities by the filter, an operation of distillation, or the like.

The polishing composition disclosed herein may further contain an organic solvent (lower alcohol, lower ketone, or the like) that can be uniformly mixed with water, if necessary. Normally, it is preferable that 90 vol% or more of a solvent contained in the polishing composition is water, and it is more preferable that 95 vol% or more thereof (for example, 99 to 100 vol%) is water.

<Other components>

The polishing composition disclosed herein may further contain well-known additives that can be used in a polishing composition (for example, a polishing composition to be used in a polishing process of a silicon wafer), such as water-soluble polymers, surfactants, acids, chelating agents, antiseptic agents, and antifungal agents if necessary, as long as the effects of the present invention are not significantly impaired.

The water-soluble polymers may be used alone or in combination of two or more kinds. Examples of the water-soluble polymer include a cellulose derivative, a starch derivative, polymers containing an oxyalkylene unit, polymers containing a nitrogen atom, vinyl alcohol-based polymers, polymers containing a carboxylic acid (including an anhydride) and the like. Specific examples thereof include hydroxyethyl cellulose, pullulan, random copolymers or block copolymers of ethylene oxide and propylene oxide, polyvinyl alcohol, polyglycerin, polyisoprene sulfonic acid, polyvinyl sulfonic acid, polyaryl sulfonic acid, polyisoamylene sulfonic acid, polystyrene sulfonate, polyacrylate, polyvinyl acetate, polyethylene glycol, polyvinylimidazole, polyvinylcarbazole, polyvinylpyrrolidone, polyacryloylmorpholine, polyvinylcaprolactam, polyvinylpiperidine, olefin-(maleic anhydride) copolymer, styrene-(maleic anhydride) copolymer and the like. The polishing composition disclosed herein can be preferably implemented in an embodiment where the composition substantially contains no water-soluble polymer, i.e., the composition does not contain a water-soluble polymer at least intentionally.

In the art disclosed herein, the molecular weight of the water-soluble polymer is not particularly limited. For example, the weight-average molecular weight (Mw) of the water-soluble polymer can be about $200 \times 10^4$ or less, with $150 \times 10^4$ or less being appropriate. The above Mw may be about $100 \times 10^4$ or less, or about $50 \times 10^4$ or less. From the viewpoint of protection of a silicon wafer surface, the above Mw is normally about $0.2 \times 10^4$ or more, and appropriately about $0.5 \times 10^4$ or more, and may be about $0.8 \times 10^4$ or more.

As the Mw of the water-soluble polymer, a value based on gel permeation chromatography (GPC) (water-based, polyethylene oxide equivalent) can be adopted.

The surfactants may be used alone or in combination of two or more kinds. Examples of the surfactant are not particularly limited, but include anionic surfactants, nonionic surfactants, cationic surfactants, and amphoteric surfactants. By using a surfactant (for example, a water-soluble organic compound having a molecular weight of less than $0.2 \times 10^4$),

the dispersion stability of the polishing composition can be improved. As the Mw of the surfactant, a value determined by GPC (water-based, polyethylene glycol equivalent) or a value calculated from a chemical formula can be adopted.

The acids may be used alone or in combination of two or more kinds. Examples of the above acid include inorganic acids such as hydrochloric acid, phosphoric acid, sulfuric acid, phosphonic acid, nitric acid, phosphinic acid, and boric acid; organic acids such as acetic acid, itaconic acid, succinic acid, tartaric acid, citric acid, maleic acid, glycolic acid, malonic acid, methanesulfonic acid, formic acid, malic acid, gluconic acid, alanine, glycine, lactic acid, hydroxyethylidene diphosphate (HEDP), nitrilotris(methylenephosphonic acid) (NTMP), phosphonobutane tricarboxylic acid (PBTC); and the like.

The chelating agents may be used alone or in combination of two or more kinds. Examples of the chelating agent include aminocarboxylic acid-based chelating agents and organophosphonic acid-based chelating agents. Examples of the aminocarboxylic acid-based chelating agent include ethylenediaminetetraacetic acid, sodium ethylenediaminetetraacetic acid, nitrilotriacetic acid, sodium nitrilotriacetic acid, ammonium nitrilotriacetic acid, hydroxyethylethylenediaminetriacetic acid, sodium hydroxyethylethylenediaminetriacetic acid, diethylenetriaminepentaacetic acid, sodium diethylenetriamine pentaacetic acid, triethylenetetramine hexaacetic acid and sodium triethylenetetramine hexaacetic acid. Examples of the organophosphonic acid-based chelating agent include 2-aminoethylphosphonic acid, 1-hydroxyethylidene-1,1-diphosphonic acid, aminotri(methylene phosphonic acid), ethylenediamine tetrakis(methylene phosphonic acid), diethylenetriamine penta(methylene phosphonic acid), ethane-1,1-diphosphonic acid, ethane-1,1,2-triphosphonic acid, ethane-1-hydroxy-1,1-diphosphonic acid, ethane-1-hydroxy-1,1,2-triphosphonic acid, ethane-1,2-dicarboxy-1,2-diphosphonic acid, methane hydroxyphosphonic acid, 2-phosphonobutane-1,2-dicarboxylic acid, 1-phosphonobutane-2,3,4-tricarboxylic acid and $\alpha$-methylphosphonosuccinic acid. Among them, organophosphonic acid-based chelating agents are more preferable. Among them, preferred examples thereof include ethylenediamine tetrakis(methylene phosphonic acid), diethylenetriamine penta(methylene phosphonic acid), and diethylenetriaminepentaacetic acid. Particularly preferable examples of the chelating agent include ethylenediamine tetrakis(methylene phosphonic acid) and diethylenetriamine penta(methylenephosphonic acid).

Examples of the antiseptic agent and the antifungal agent include isothiazoline-based compounds, paraoxybenzoic acid esters, phenoxyethanol and the like.

It is preferable that the polishing composition disclosed herein contains substantially no oxidant. If the polishing composition contains an oxidant, the surface of a substrate (for example, a silicon wafer surface) is oxidized by being supplied with the polishing composition to form an oxide film, which can thereby reduce the polishing removal rate. Here, the polishing composition containing substantially no oxidant means that the oxidant is not blended at least intentionally, and a trace amount of the oxidant that is inevitably contained due to raw materials, manufacturing method and the like is allowed to be present. The trace amount means that the molar concentration of the oxidant in the polishing composition is 0.0005 mol/L or less (preferably 0.0001 mol/L or less, more preferably 0.00001 mol/L or less, and particularly preferably 0.000001 mol/L or less). The polishing composition according to a preferred embodiment does not contain an oxidant. The polishing composition disclosed herein can be preferably implemented in an embodiment where it does not contain, for example, any of hydrogen peroxide, sodium persulfate, ammonium persulfate, and sodium dichloroisocyanurate.

<Polishing Composition>

The polishing composition disclosed herein is supplied to an object to be polished in the form of, for example, a polishing slurry (working slurry) containing the polishing composition, and it is used to polish the object. For example, the polishing compositions disclosed herein may be diluted (e.g., diluted with water) and used as a polishing slurry, or may be used in the form of the polishing slurry as it is. That is, the concept of the polishing composition in the art disclosed herein is inclusive of both a working slurry supplied to the object to be polished and used for polishing the object to be polished, and a concentrate (a stock solution) of the working slurry. The concentration factor of the above concentrate may be, for example, about 2 to 140 times on a volume basis, and normally appropriately about 5 to 80 times.

A pH of the polishing composition is 9.0 or higher, and preferably 9.5 or higher, and may be 10.0 or higher (for example, 10.5 or higher). As the pH of the polishing composition becomes higher, the polishing removal rate tends to improve. In contrast, from the viewpoint of preventing dissolution of an abrasive (for example, silica particles) and suppressing reduction in the mechanical polishing effect with the abrasive, the pH of the polishing slurry is normally appropriately 12.0 or lower, preferably 11.8 or lower, and more preferably 11.5 or lower. These pH values can be preferably applied to the pH of either the polishing slurry (working slurry) supplied to an object to be polished or its condensate.

The pH of the polishing composition can be grasped by performing three-point calibration using a standard buffer solution (a phthalate pH buffer solution, pH: 4.01 (at 25°C), a neutral phosphate pH buffer solution, pH: 6.86 (at 25°C), and a carbonate pH buffer solution, pH: 10.01 (at 25°C)) by using a pH meter (for example, a glass electrode type hydrogen ion concentration indicator manufactured by Horiba Ltd., (model number F-23)), then placing a glass electrode in the polishing composition, and measuring its pH value after two minutes or more have passed to stabilize the polishing composition.

The polishing composition disclosed herein may be of a one-pack type or a multi-pack type such as a two-pack type. For example, the polishing slurry may be configured to be prepared by mixing Part A including at least the abrasive among the constituent components of the polishing composition and Part B including the remaining components, and diluting the mixture at appropriate timing if necessary.

A method for producing the polishing composition disclosed herein is not particularly limited. For example, the respective components constituting the polishing composition may be mixed using a known mixing device such as a blade type stirrer, an ultrasonic disperser, or a homomixer. The mode of mixing these components is not particularly limited. For example, all the components may be mixed at once, or may be mixed in a suitably set order.

<Polishing>

The polishing composition disclosed herein can be used for polishing an object to be polished, for example, in an embodiment including the following operations.

That is, a working slurry containing any one of the polishing compositions disclosed herein is prepared. Then, the polishing composition is supplied to the object to be polished, and the object is polished by a conventional method. For example, an object to be polished is set in a general polishing machine, and the polishing composition is supplied to the surface of the object to be polished (the surface to be polished) through a polishing pad of the polishing machine. For example, the polishing pad is pressed against the surface of the object to be polished while continuously supplying the above polishing composition thereto, and both the object and the polishing pad are relatively moved (for example, rotated). Through such a polishing process, the polishing of the object is completed.

The polishing pad used in the above polishing process is not particularly limited. For example, polishing pads of any type such as a polyurethane foam type, a non-woven fabric type, and a suede type, and a polishing pad containing an abrasive or containing no abrasive can be used. The above polishing machine may be a double-side polishing machine that polishes both sides of the object to be polished simultaneously, or a single-side polishing machine that polishes only one side of the object to be polished.

The above polishing composition may be used in a disposable manner (so-called "in one-way") once used for polishing, or may be circulated and reused repeatedly. As an example of circulating and reusing the polishing composition, there is a proposed method that involves collecting, in a tank, a used polishing composition discharged from a polishing machine and supplying the collected polishing composition to the polishing machine again.

<Applications>

The polishing composition disclosed herein can be applied to polishing of objects to be polished that are made of various materials and have various shapes. The material of the object to be polished is, for example, a metal or metalloid such as silicon, aluminum, nickel, tungsten, copper, tantalum, titanium, and stainless steel and alloys thereof; a glassy substance such as quartz glass, aluminosilicate glass, and glassy carbon; a ceramic material such as alumina, silica, sapphire, silicon nitride, tantalum nitride, and titanium carbide; a compound semiconductor substrate material such as silicon carbide, gallium nitride, and gallium arsenide; a resin material such as polyimide resin; and the like. The object to be polished may be composed of a plurality of these materials.

The polishing composition disclosed herein is suitable for use in polishing a semiconductor substrate, such as a silicon wafer. The above polishing composition has excellent ability in cancellation of bumps at the periphery of the HLM (the bump cancellation ability) and can be preferably applied to polishing a surface to be polished, including the surface marked with HLM. The polishing composition disclosed herein can be preferably used particularly in a preliminary polishing step, more specifically, a rough polishing step (primary polishing step), which is an initial polishing step in the polishing process, and a subsequent intermediate polishing step (secondary polishing step).

The silicon wafer may be subjected to general treatment such as lapping, etching, and marking of HLM described above, before the polishing process using the polishing composition disclosed herein.

The above silicon wafer has a surface made of silicon, for example. Such a silicon wafer is suitably a silicon single crystal wafer, for example, a silicon single crystal wafer obtained by slicing a silicon single crystal ingot.

The polishing composition disclosed herein is suitable for applications of polishing a silicon single crystal wafer marked with HLM. The polishing composition disclosed herein can also be suitable used for polishing an object to be polished that does not have HLM.

[Examples]

Several examples relating to the present invention will be described below, but the present invention is not intended to be limited to those described in the examples.

<Preparation of Polishing Composition>

(Example 1)

Colloidal silica (average primary particle diameter: 55 nm, average secondary particle diameter: 105 nm, non-globular) as an abrasive, tetramethylammonium hydroxide (TMAH) as a basic compound, potassium carbonate and potassium silicate as pH buffering agents, and ion exchange water were mixed to prepare a concentrate of the polishing composition. The resulting concentrate of the polishing composition was diluted to 10 times on a volume basis with ion exchange water, thereby producing a polishing composition that contained 0.5 wt% of colloidal silica, 0.23 wt% of TMAH, and each component of a pH buffering agent at a concentration shown in Table 1. The term wt% in Table 1 refers to % by weight. The pH of the polishing composition according to the present example was 10.94 as shown in Table 1. The average secondary particle diameter of the abrasive is a value measured by "FPAR-1000" manufactured by Otsuka Electronics Co.,Ltd.

(Example 2)

A polishing composition according to this example was prepared in the same manner as Example 1 except that colloidal silica (average primary particle diameter: 45 nm, average secondary particle diameter: 70 nm, globular) was used. The pH of the polishing composition according to this example was 10.92 as shown in Table 1. The average secondary particle diameter of the abrasive was a value measured by "FPAR-1000" manufactured by Otsuka Electronics Co.,Ltd.

(Example 3)

A polishing composition according to this example was prepared in the same manner as Example 2 except that tetramethylammonium hydrogen carbonate was further added in the pH buffering agent with the concentration of each component of the pH buffering agent being set as shown in Table 1. The pH of the polishing composition according to this example was 10.93 as shown in Table 1.

(Comparative Example 1)

A polishing composition according to this example was prepared in the same manner as in Example 1 except that potassium silicate was not used. The pH of the polishing composition according to this example was 10.72 as shown in Table 1.

(Comparative Example 2)

A polishing composition according to this example was prepared in the same manner as in Example 2 except that potassium silicate was not used. The pH of the polishing composition according to this example was 10.71 as shown in Table 1.

(Comparative Example 3)

A polishing composition according to this example was prepared in the same manner as in Example 2 except that potassium carbonate was not used. The pH of the polishing composition according to this example was 10.92 as shown in Table 1.

(Comparative Example 4)

A polishing composition according to this example was prepared in the same manner as in Example 2 except that potassium carbonate was not used with the concentration of potassium silicate being set as shown in Table 1. The pH of the polishing composition according to this example was 10.95 as shown in Table 1.

<Performance Evaluation>

(Polishing of silicon wafer)

The surface of an object to be polished (test piece) was polished under the following conditions using the polishing composition according to each example as it was, as the polishing slurry (working slurry). As the test piece, a commercially available silicon single crystal wafer (thickness: 525 $\mu$m, conductivity type: P type, crystal orientation:

<100>, resistivity: 0.1 Ω·cm or more and less than 100 Ω·cm) having a diameter of 100 mm after lapping and etching was used. The wafer was marked with HLM.

(Polishing conditions)

Polishing machine: Single-side polishing machine, model "EJ-380IN" manufactured by Engis Japan Corporation
Polishing pressure: 12 kPa
Platen rotational speed: 50 rpm
Head rotational speed: 40 rpm
Polishing pad: trade name "SUBA800" manufactured by Nitta Haas Incorporated
Flow rate of polishing slurry: 50 mL/minute (used in one-way)
Holding temperature of polishing environment: about 25°C
Polishing time: 17 minutes

(Evaluation of HLM flatness)

In a silicon wafer after polishing, the contour of the surface at the periphery of the HLM was measured by using a stylus surface roughness tester (SURFCOM 1500DX, manufactured by TOKYO SEIMITSU CO., LTD.). Specifically, the stylus of the meter was brought into contact with the surface of the substrate, and the part at the periphery of the HLM was scanned by the stylus, whereby the height of a part with no bumps (reference surface) and the height of the bump were measured. The "HLM flatness" is defined as a height ($\mu$m) from the reference surface to the highest point of the bump. The results obtained are shown in the "HLM flatness" column of Table 1. A substrate with an HLM flatness of less than 0.6 $\mu$m is evaluated to have favorable HLM flatness, and the used polishing composition is evaluated to have excellent bump cancellation ability. In contrast, a substrate with an HLM flatness of 0.6 $\mu$m or more is evaluated to have bad HLM flatness, and the used polishing composition is evaluated to have poor bump cancellation ability.

<Evaluation of Polishing Removal Rate>

The polishing removal rate R [cm/min] in each of Examples and Comparative Examples was calculated by the following formulas (1) to (3), based on a difference in the weight of the wafer before and after the polishing. The obtained polishing removal rate R was transformed into a relative value (relative polishing removal rate [%]) on the assumption that the polishing removal rate of Comparative Example 1 was 100%. The results obtained are shown in the "Relative polishing removal rate" column of Table 1. A wafer having a relative polishing removal rate of 100% or more is rated as a pass, while a wafer having a relative polishing removal rate of less than 100% is rated as a fail.
Formulas:

$$\Delta V = (W0 - W1)/d \qquad (1)$$

$$\Delta x = \Delta V/S \qquad (2)$$

$$R = \Delta x/t \qquad (3)$$

$\Delta V$: Change in volume of wafer before and after polishing
WO: Weight of wafer before polishing [g]
W1: Weight of wafer after polishing [g]
d: Specific gravity of silicon (2.33)[g/cm$^3$]
S: Surface area of wafer [cm$^2$]
$\Delta x$: Change in thickness of wafer before and after polishing [cm]
t : Polishing time [min]

[Table 1]

Table 1

| | Silica primary particle size [nm] | Potassium carbonate [wt%] | Tetramethylammonium bicarbonate [wt%] | Potassium silicate [wt%] | pH | HLM flatness [$\mu$m] | Relative polishing removal rate [%] |
|---|---|---|---|---|---|---|---|
| Example 1 | 55 | 0.17 | - | 0.20 | 10.94 | 0.51 | 100 |
| Example 2 | 45 | 0.17 | - | 0.20 | 10.92 | 0.45 | 100 |
| Example 3 | 45 | 0.05 | 0.17 | 0.20 | 10.93 | 0.51 | 100 |
| Comparative Example 1 | 55 | 0.17 | - | - | 10.72 | 0.78 | 100 |
| Comparative Example 2 | 45 | 0.17 | - | - | 10.71 | 0.72 | 100 |
| Comparative Example 3 | 45 | - | - | 0.20 | 10.92 | 0.68 | 97 |
| Comparative Example 4 | 45 | - | - | 0.37 | 10.95 | 0.66 | 97 |

As shown in Table 1, in Comparative Examples 3 and 4 using polishing compositions containing an abrasive, a basic compound, a pH buffering agent, and water, while the pH buffering agent contains only potassium silicate having a pKa value of 12 or more, the HLM flatness was slightly improved, but the polishing removal rate was lowered, compared to Comparative Examples 1 and 2 using polishing compositions containing only potassium carbonate having a pKa value in the range of 9 to 11 as the pH buffering agent. In contrast, in Examples 1 to 3 using the polishing compositions containing, as the pH buffering agent, both potassium carbonate having a pKa value in the range of 9 to 11 and potassium silicate having a pKa value of 12 or more, the HLM flatness was significantly improved while maintaining the practical polishing removal rate, compared to Comparative Examples 1 to 4 that contained only one of the pH buffering agent having a pKa value in the range of 9 to 11 and the pH buffering agent having a pKa value of 12 or more. From these results, it is found that the use of the polishing composition that contains the salt $S_L$ having at least one of pKa values in the range of 9 to 11 and the salt $S_H$ having at least one of pKa values of 12 or more as the pH buffering agent can achieve both high polishing removal rate and excellent bump cancellation ability at the periphery of the HLM. Note that although not shown in Table 1, it was confirmed that the polishing composition of Example 3 further containing a salt having an organic carbon as the pH buffering agent had more excellent dispersion stability in the state of a concentrate before the dilution.

While specific examples of the present invention have been described above in detail, these are only examples, and do not limit the scope of the claims.

**Claims**

1. A polishing composition comprising: an abrasive; a basic compound; a pH buffering agent; and water, wherein

    the polishing composition contains the abrasive in an amount of 10 weight% or less,
    the pH buffering agent contains a salt $S_L$ and a salt $S_H$, the salt $S_L$ having at least one of acid dissociation constant (pKa) values in a range of 9 to 11 and the salt $S_H$ having at least one of pKa values of 12 or more,
    the salt $S_H$ comprises at least one salt of a compound selected from the group consisting of silicic acid, germanic acid, arginine, nitrilotrismethylphosphonic acid, phosphoric acid and tetramethylguanidine, wherein the salt $S_H$ comprises an alkali metal salt,
    a ratio ($C_H/C_L$) of a content ($C_H$) of the salt $S_H$ to a content ($C_L$) of a salt $S_L$ is 0.1 or more and 10 or less, and
    the pH of the polishing composition is 9.0 or higher.

2. The polishing composition according to claim 1, wherein the salt $S_L$ contains a carbonate.

3. The polishing composition according to claim 1 or 2, wherein the pH buffering agent contains a salt having an organic carbon.

4. The polishing composition according to claim 3, wherein the salt having the organic carbon is selected from an organic carbonate and an organic hydrogen carbonate.

5. The polishing composition according to any one of claims 1 to 4, wherein the abrasive contains silica particles.

6. The polishing composition according to any one of claims 1 to 5, wherein the basic compound contains a quaternary ammonium hydroxide.

7. The polishing composition according to any one of claims 1 to 6, wherein the polishing composition is used in a polishing process of a silicon wafer marked with a hard laser mark.

**Patentansprüche**

1. Polierzusammensetzung, umfassend: ein Poliermittel, eine basische Verbindung, ein pH-Puffermittel und Wasser, wobei

die Polierzusammensetzung das Poliermittel in einer Menge von 10 Gew.-% oder weniger enthält,
das pH-Puffermittel ein Salz $S_L$ und ein Salz $S_H$ enthält, wobei das Salz $S_L$ mindestens einen von Säure-Dissoziationskonstantenwerten (pKa) im Bereich von 9 bis 11 und das Salz $S_H$ mindestens einen von pKa-Werten von 12 oder mehr aufweist,
das Salz $S_H$ mindestens ein Salz einer Verbindung umfasst, welche aus der Gruppe, die aus Kieselsäure, Germaniumsäure, Arginin, Nitrilotrimethylphosphonsäure, Phosphorsäure und Tetramethylguanidin besteht, ausgewählt ist, wobei das Salz $S_H$ ein Alkalimetallsalz umfasst,
ein Verhältnis ($C_H/C_L$) eines Gehalts ($C_H$) des Salzes $S_H$ zu einem Gehalt ($C_L$) eines Salzes $S_L$ 0,1 oder mehr und 10 oder weniger beträgt, und
der pH-Wert der Polierzusammensetzung 9,0 oder höher ist.

2. Polierzusammensetzung gemäß Anspruch 1, wobei das Salz $S_L$ ein Carbonat enthält.

3. Polierzusammensetzung gemäß Anspruch 1 oder 2, wobei das pH-Puffermittel ein Salz mit einem organischen Kohlenstoff enthält.

4. Polierzusammensetzung gemäß Anspruch 3, wobei das Salz mit dem organischen Kohlenstoff aus einem organischen Carbonat und einem organischen Hydrogencarbonat ausgewählt ist.

5. Polierzusammensetzung gemäß einem der Ansprüche 1 bis 4, wobei das Poliermittel Siliciumdioxidpartikel enthält.

6. Polierzusammensetzung gemäß einem der Ansprüche 1 bis 5, wobei die basische Verbindung ein quaternäres Ammoniumhydroxid enthält.

7. Polierzusammensetzung gemäß einem der Ansprüche 1 bis 6, wobei die Polierzusammensetzung in einem Polierprozess eines mit einer Hartlasermarkierung gekennzeichneten Siliziumwafers verwendet wird.

**Revendications**

1. Composition de polissage comprenant : un abrasif ; un composé basique ; un agent tampon de pH ; et de l'eau, dans laquelle

la composition de polissage contient l'abrasif à hauteur de 10 % en poids ou moins,
l'agent tampon de pH contient un sel $S_L$ et un sel $S_H$, le sel $S_L$ ayant au moins l'une parmi des valeurs de constante de dissociation d'acide (pKa) dans une plage de 9 à 11 et le sel $S_H$ ayant au moins l'une parmi des valeurs de pKa égales à 12 ou plus,
le sel $S_H$ comprend au moins un sel d'un composé choisi dans le groupe constitué par l'acide silicique, l'acide germanique, l'arginine, l'acide nitrilotrismé-thylphosphonique, l'acide phosphorique et la tétraméthylguanidine, dans laquelle le sel $S_H$ comprend un sel de métal alcalin,
un rapport ($C_H/C_L$) d'une teneur ($C_H$) du sel $S_H$ à une teneur ($C_L$) d'un sel $S_L$ est de 0,1 ou plus et 10 ou moins, et

le pH de la composition de polissage est supérieur ou égal à 9,0.

2. Composition de polissage selon la revendication 1, dans laquelle le sel $S_L$ contient un carbonate.

3. Composition de polissage selon la revendication 1 ou 2, dans laquelle l'agent tampon de pH contient un sel ayant un carbone organique.

4. Composition de polissage selon la revendication 3, dans laquelle le sel ayant le carbone organique est choisi parmi un carbonate organique et un hydro-génocarbonate organique.

5. Composition de polissage selon l'une quelconque des revendications 1 à 4, dans laquelle l'abrasif contient des particules de silice.

6. Composition de polissage selon l'une quelconque des revendications 1 à 5, dans laquelle le composé basique contient un hydroxyde d'ammonium quaternaire.

7. Composition de polissage selon l'une quelconque des revendications 1 à 6, dans laquelle la composition de polissage est utilisé dans un procédé de polissage d'une tranche de silicium marqué par une marque laser profonde.

## REFERENCES CITED IN THE DESCRIPTION

**Patent documents cited in the description**

- JP 2019180257 A
- WO 2019221258 A
- CN 105623526 A
- CN 107828340 A
- JP H9306880 B
- JP 2018107223 A